(19) Europäisches Patentamt
European Patent Office
Office européen des brevets

(11) **EP 4 063 178 A1**

(12) **EUROPEAN PATENT APPLICATION**
published in accordance with Art. 153(4) EPC

(43) Date of publication:
**28.09.2022 Bulletin 2022/39**

(51) International Patent Classification (IPC):
**B60L 58/12** *(2019.01)*

(21) Application number: **21760211.9**

(52) Cooperative Patent Classification (CPC):
Y02T 10/70

(22) Date of filing: **25.02.2021**

(86) International application number:
**PCT/CN2021/077832**

(87) International publication number:
**WO 2021/170025 (02.09.2021 Gazette 2021/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.02.2020 CN 202010115664**

(71) Applicant: **Great Wall Motor Company Limited
Baoding, Hebei 071000 (CN)**

(72) Inventors:
• ZHAO, Qing
  **Baoding, Hebei 071000 (CN)**
• CHEN, Shujiang
  **Baoding, Hebei 071000 (CN)**

(74) Representative: **Klunker IP
Patentanwälte PartG mbB
Destouchesstraße 68
80796 München (DE)**

(54) **METHOD AND DEVICE FOR CONTROLLING LOWER LIMIT OF STATE OF CHARGE OF POWER BATTERY, AND VEHICLE**

(57) The present disclosure relates to the technical field of new energy vehicles, and provides a method and a device for controlling a lower limit of a state of charge of a power battery, and a vehicle. The method provided by the present disclosure includes: detecting a minimum ambient temperature for at least a period of time; predicting a minimum ambient temperature within a preset period of time after the at least a period of time according to the minimum ambient temperature within the at least a period of time; determining, according to the minimum ambient temperature within the preset period of time, a minimum state of charge value that able to meet power requirements for starting an engine of a vehicle under the minimum ambient temperature within the preset period of time; and adjusting a lower limit of the state of charge according to the minimum state of charge value. The present disclosure can ensure that the SOC value of the battery can enable the vehicle to start normally in a low ambient environment.

| Step S11 | detecting a minimum ambient temperature for at least a period of time; |
| Step S12 | predicting a minimum ambient temperature within a preset period of time after the at least a period of time according to the minimum ambient temperature within the at least a period of time; |
| Step S13 | determining, according to the minimum ambient temperature within the preset period of time, a minimum state of charge value that able to meet power requirements for starting an engine of a vehicle under the minimum ambient temperature within the preset period of time; |
| Step S14 | adjusting a lower limit of the state of charge according to the minimum state of charge value. |

Fig. 1

## Description

## CROSS REFERENCE TO RELATED APPLICATION

The applicant claimed priority of Chinese Patent application, with Application No. 202010115664.8, filed on February 25, 2020, Titled "a method and a device for controlling a lower limit of a state of charge of a power battery, and a vehicle", submitted to CNIPA, the content of which is incorporated herein by reference.

## TECHNICAL FIELD

The present disclosure relates to the technical field of new energy vehicles, and more particularly to a method and a device for controlling a lower limit of a state of charge of a power battery, and a vehicle.

## BACKGROUND

With the increasing emergence of energy crisis and environmental pollution, hybrid vehicles have become an important direction for the development of the automotive industry due to their outstanding advantages in energy saving and environmental protection. At present, the lower limit of the state of charge (SOC) of the power battery used in hybrid vehicles is constant during the use of the vehicle. When the battery of the vehicle is at a low SOC value and is powered off, the low SOC value of the battery may be insufficient to enable the vehicle to start normally at low temperature due to the decrease in ambient temperature, thus affecting the normal function of the vehicle when powering on next time.

## SUMMARY

In view of this, the present disclosure aims to provide a method and a device for controlling a lower limit of a state of charge of a power battery, and a vehicle, to ensure that the SOC value of the battery can enable the vehicle to start normally in a low ambient environment.

In order to achieve above object, the technical solution of the present disclosure is achieved as following:

A method for controlling a lower limit of a state of charge of a power battery, and the method includes:

detecting a minimum ambient temperature for at least a period of time;
predicting a minimum ambient temperature within a preset period of time after the at least a period of time according to the minimum ambient temperature within the at least a period of time;
determining, according to the minimum ambient temperature within the preset period of time, a minimum state of charge value that able to meet power requirements for starting an engine of a vehicle under the minimum ambient temperature within the preset period of time; and
adjusting a lower limit of the state of charge according to the minimum state of charge value.

In one embodiment, the minimum ambient temperature within the at least a period of time only includes a minimum ambient temperature within a first period of time, and the step of predicting a minimum ambient temperature within a preset period of time after the at least a period of time according to the minimum ambient temperature within the at least a period of time includes:
calculating the minimum ambient temperature within the preset period of time according to the minimum ambient temperature within the first period of time, a temperature constant, and a first ambient temperature predictive factor.

In one embodiment, the minimum ambient temperature within the at least a period of time includes a minimum ambient temperature within a first period of time and a minimum ambient temperature within a second period of time, the second period of time being after the first period of time, and the step of predicting a minimum ambient temperature within a preset period of time after the at least a period of time according to the minimum ambient temperature within the at least a period of time includes:
predicting the minimum ambient temperature within the preset period of time is the minimum ambient temperature within the first period of time, when determining that the minimum ambient temperature within the first period of time is less than or equal to the minimum ambient temperature within the second period of time.

In one embodiment, the minimum ambient temperature within the at least a period of time includes a minimum ambient temperature within a first period of time and a minimum ambient temperature within a second period of time, the second period of time being after the first period of time, and the step of predicting a minimum ambient temperature within a preset period of time after the at least a period of time according to the minimum ambient temperature within the at least a period of time includes:
calculating the minimum ambient temperature within the preset period of time according to the minimum ambient temperature within the first period of time, the minimum ambient temperature within the second period of time, and a second ambient temperature predictive factor, when determining that the minimum ambient temperature within the first period of time is larger than the minimum ambient temperature within the second period of time.

In one embodiment, the step of determining, according to the minimum ambient temperature within the preset period of time, a minimum state of charge value that able to meet power requirements for starting an engine of a vehicle under the minimum ambient temperature within the preset period of time includes:

substituting the minimum ambient temperature within the preset period of time in a discharge power Map of the power battery to obtain the minimum state of charge value.

Compared with the prior art, the method for controlling a lower limit of a state of charge of a power battery of the present disclosure has the following advantages: The present disclosure adopts a method for controlling a lower limit of a state of charge of a power battery, which includes: detecting a minimum ambient temperature for at least a period of time; predicting a minimum ambient temperature within a preset period of time after the at least a period of time according to the minimum ambient temperature within the at least a period of time; determining, according to the minimum ambient temperature within the preset period of time, a minimum state of charge value that able to meet power requirements for starting an engine of a vehicle under the minimum ambient temperature within the preset period of time; and adjusting a lower limit of the state of charge according to the minimum state of charge value. Since the minimum ambient temperature in the future preset period of time is predicted, therefore, the lower limit of the SOC of the battery is adjusted according to the minimum ambient temperature in the future preset period of time, so that the SOC value of the battery of the vehicle is not lower than the lower limit, so as to ensure that the SOC value of the battery can enable the vehicle to start normally in a low temperature environment.

Another object of the present disclosure is to provide a device for controlling a lower limit of a state of charge of a power battery, so as to ensure that the SOC value of the battery can enable the vehicle to start normally in a low temperature environment.

In order to achieve above object, the technical solution of the present disclosure is achieved as following:

A device for controlling a lower limit of a state of charge of a power battery, and the device includes: a detection unit, configured for detecting a minimum ambient temperature for at least a period of time; a prediction unit, configured for predicting a minimum ambient temperature within a preset period of time after the at least a period of time according to the minimum ambient temperature within the at least a period of time; and a processing unit, configured for: determining, according to the minimum ambient temperature within the preset period of time, a minimum state of charge value that able to meet power requirements for starting an engine of a vehicle under the minimum ambient temperature within the preset period of time; and adjusting a lower limit of the state of charge according to the minimum state of charge value.

In one embodiment, the minimum ambient temperature within the at least a period of time only includes a minimum ambient temperature within a first period of time, and the prediction unit is configured for calculating the minimum ambient temperature within the preset period of time according to the minimum ambient temperature within the first period of time, a temperature constant, and a first ambient temperature predictive factor.

In one embodiment, the minimum ambient temperature within the at least a period of time includes a minimum ambient temperature within a first period of time and a minimum ambient temperature within a second period of time, the second period of time being after the first period of time, and the prediction unit is configured for predicting the minimum ambient temperature within the preset period of time is the minimum ambient temperature within the first period of time, when determining that the minimum ambient temperature within the first period of time is less than or equal to the minimum ambient temperature within the second period of time.

In one embodiment, the minimum ambient temperature within the at least a period of time includes a minimum ambient temperature within a first period of time and a minimum ambient temperature within a second period of time, the second period of time being after the first period of time, and the prediction unit is configured for calculating the minimum ambient temperature within the preset period of time according to the minimum ambient temperature within the first period of time, the minimum ambient temperature within the second period of time, and a second ambient temperature predictive factor, when determining that the minimum ambient temperature within the first period of time is larger than the minimum ambient temperature within the second period of time.

In one embodiment, the processing unit is configured for substituting the minimum ambient temperature within the preset period of time in a discharge power Map of the power battery to obtain the minimum state of charge value.

The device for controlling a lower limit of a state of charge of a power battery and the method for controlling a lower limit of a state of charge of a power battery have the same advantages relative to the prior art, which is not repeated herein.

Another object of the present disclosure provides a vehicle, so as to ensure that the SOC value of the battery can enable the vehicle to start normally in a low temperature environment.

In order to achieve above object, the technical solution of the present disclosure is achieved as following:

A vehicle includes the device for controlling a lower limit of a state of charge of a power battery above-mentioned.

The vehicle and the device for controlling a lower limit of a state of charge of a power battery have the same advantages relative to the prior art, which is not repeated herein.

Another object of the present disclosure provides a machine-readable storage medium, so as to ensure that the SOC value of the battery can enable the vehicle to start normally in a low temperature environment.

In order to achieve above object, the technical solution of the present disclosure is achieved as following:

A machine-readable storage medium storing with instructions, and the instructions are configured to execute the method for controlling a lower limit of a state of charge of a power battery above-mentioned.

The machine-readable storage medium and the method for controlling a lower limit of a state of charge of a power battery have the same advantages relative to the prior art, which is not repeated herein.

Other features and advantages of the present disclosure will be described in detail in the detailed description that follows.

**BRIEF DESCRIPTION OF THE DRAWINGS**

The accompanying drawings constituting a part of the present disclosure are used to provide further understanding of the present disclosure, and the schematic embodiments of the present disclosure and descriptions thereof are used to explain the present disclosure and do not constitute an improper limitation of the present disclosure. In the drawings:

Fig. 1 is a flowchart of a method for controlling a lower limit of a state of charge of a power battery provided by an embodiment of the present disclosure;

Figs. 2A and 2B are flowcharts of a method for controlling a lower limit of a state of charge of a power battery provided by another embodiment of the present disclosure; and

Fig. 3 is a structural block diagram of a device for controlling a lower limit of a state of charge of a power battery provided by an embodiment of the present disclosure.

In the drawings, the reference signs are listed:

1-detection unit; 2-prediction unit; and 3-processing unit.

**DETAILED DESCRIPTION OF EMBODIMENTS**

It should be noted that the embodiments of the present disclosure and the features of the embodiments can be combined with each other according to actual needs.

The present disclosure will be described in detail below with reference to the accompanying drawings and in conjunction with the embodiments.

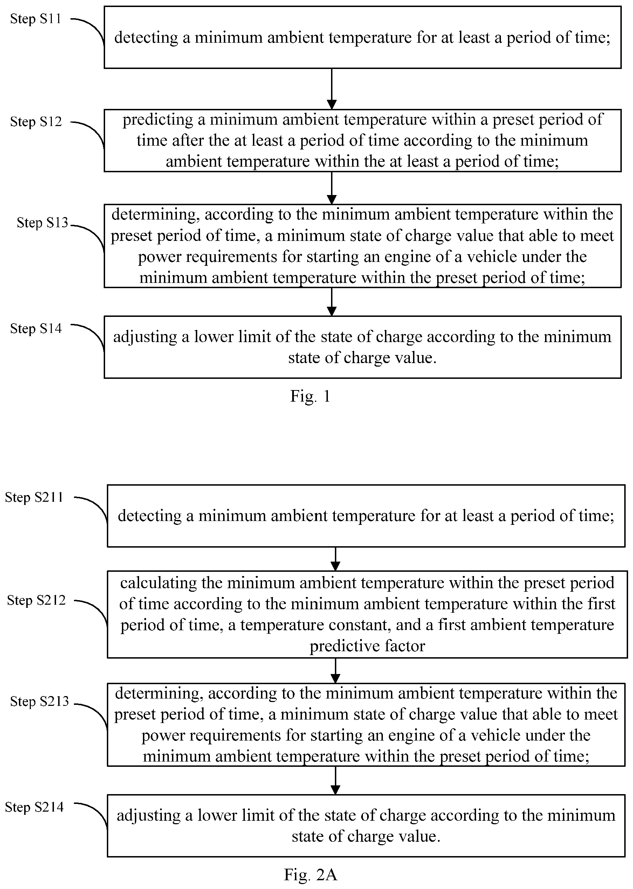

Fig. 1 is a flowchart of a method for controlling a lower limit of a state of charge of a power battery provided by an embodiment of the present disclosure. As shown in Fig. 1, the method includes:

Step S11, detecting a minimum ambient temperature for at least a period of time;

Specifically, the ambient temperature can be detected by using a temperature sensor, and then the minimum ambient temperature can be calculated after the ambient temperature is stored. The at least a period of time can be, for example, a period of time, such as 5 days, 10 days, or 30 days; or two periods of time, such as two 5 days. If the at least a period of time represents two periods of time, then the respective minimum ambient temperatures of the two periods of time are obtained.

In one embodiment, since the present disclosure is directed to a vehicle, each functional device on the vehicle can also be used to perform the processing of detecting the minimum ambient temperature. For example, specifically:

The battery management system (BMS) wakes up from time to time (can be a plurality of times a day) and then wakes up the CAN network of the vehicle, and then waits for sleep; or T-Box wakes up from time to time (can be a plurality of times a day) and then wakes up the CAN network of the vehicle, and then waits for sleep. The air-conditioning controller is then woken up and sends the current ambient temperature to the hybrid vehicle unit (HCU), and then waits for sleep. After the head unit system (HUT) is woken up, the HUT sends the current date and time to the HCU, and then waits for sleep. After the HCU is woken up, the HCU receives the ambient temperature and updates the received ambient temperature to the ambient temperature record of the day, the minimum ambient temperature of the day is calculated based on the valid ambient temperature record of the day (not equal to the default value of 100, if the temperature detection of the air conditioner controller fails, the temperature is invalid), and then the minimum ambient temperature of the day is recorded, so that the minimum ambient temperature in any period of time can be obtained according to the daily minimum ambient temperature. If the daily ambient temperature records are invalid for a certain period of time (that is, the default value of 100), the minimum ambient temperature for that period is also invalid (that is, the default value of 100).

Step S12, predicting a minimum ambient temperature within a preset period of time after the at least a period of time according to the minimum ambient temperature within the at least a period of time;

Specifically, as shown in Fig. 2A, if at least a period of time is only a period of time, such as a first period of time, or at least a period of time is two periods of time, but the minimum ambient temperature for one of the two periods of time is invalid (that is, the default value of 100) , then in this case, step S212 is performed instead of step S12, calculating the minimum ambient temperature within the preset period of time according to the minimum ambient temperature within the first period of time, a temperature constant, and a first ambient temperature predictive factor. The specific calculation formula is:

$$T0 = T1 + C \times q1$$

The T0 represents the minimum ambient temperature in the preset period of time; the T1 represents the minimum ambient temperature in the first period of time; the C represents the temperature constant; and the q1 represents the first ambient temperature predictive factor. The temperature constant is, for example, -5°C, and this value can be calibrated according to actual needs. The first ambient temperature predictive factor can be obtained by substituting the minimum ambient temperature T1 in the first period of time and querying the "correspondence table between the ambient temperature predictive factor and the minimum ambient temperature". The first ambient temperature predictive factor q1 is preferably ranged from 0 to 2. The "correspondence table between the ambient temperature predictive factor and the minimum ambient temperature" can be obtained by pre-calibration. For example, when the minimum ambient temperature for the next 10 days (that is, the preset period of time above) is needed to be predicted based on the minimum ambient temperature of the first 10 days, after the temperature constant C is set, then the minimum ambient temperature for the first 10 days is detected, and the minimum ambient temperature for the next 10 days is detected, and then substituting the minimum ambient temperatures in the above formula $T0 = T1 + C \times q1$ to obtain the first ambient temperature predictive factor q1, the above processing then being performed a plurality of times, the first ambient temperature predictive factor q1 corresponding to the minimum ambient temperature in the first 10 days can be obtained through a large amount of actual data. This calibration method is relatively common and will not be repeated here.

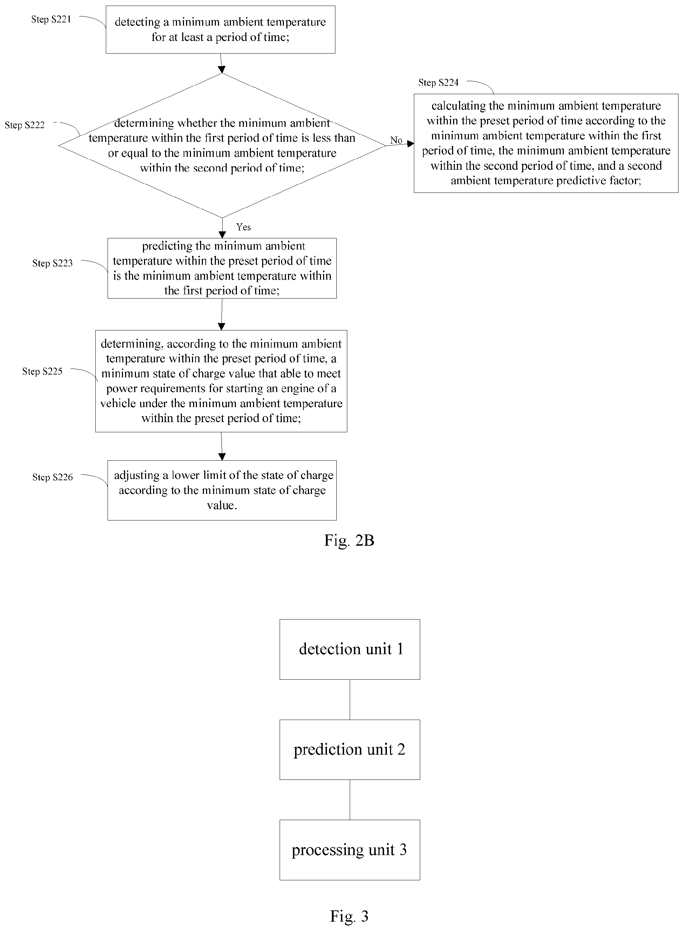

As shown in Fig. 2B, if the at least a period of time is two periods of time, namely a first period of time and a second period of time (the second period of time is after the first period of time), and when the minimum ambient temperatures of the two periods of time are valid, then perform the following steps S222-S224 instead of step S12:

Step S222, determining whether the minimum ambient temperature within the first period of time is less than or equal to the minimum ambient temperature within the second period of time;

Step S223, predicting the minimum ambient temperature within the preset period of time is the minimum ambient temperature within the first period of time, when the minimum ambient temperature within the first period of time is less than or equal to the minimum ambient temperature within the second period of time.

Step S224, calculating the minimum ambient temperature within the preset period of time according to the minimum ambient temperature within the first period of time, the minimum ambient temperature within the second period of time, and a second ambient temperature predictive factor, when the minimum ambient temperature within the first period of time is larger than the minimum ambient temperature within the second period of time.

In the step S224, the specific calculation formula is:

$$T0 = T2 + (T2 - T1) \times q2$$

The T0 represents the minimum ambient temperature in the preset period of time; the T1 represents the minimum ambient temperature in the first period of time; the T2 represents the minimum ambient temperature in the second period of time; and the q2 represents the second ambient temperature predictive factor. The second ambient temperature predictive factor q2 can be obtained by substituting the difference between the minimum ambient temperature T1 in the first period of time and the minimum ambient temperature in the second period of time and querying the "correspondence table between the ambient temperature predictive factor and the minimum ambient temperature". The second ambient temperature predictive factor q2 is preferably ranged from 0 to 2.

Step S13, determining, according to the minimum ambient temperature within the preset period of time, a minimum state of charge value that able to meet power requirements for starting an engine of a vehicle under the minimum ambient temperature within the preset period of time;

Specifically, substituting the minimum ambient temperature within the preset period of time in a discharge power Map of the power battery to obtain the minimum SOC value, the discharge power Map of the power battery is known, and the Map varies according to the vehicle or the power battery.

Step S14, adjusting a lower limit of the state of charge according to the minimum state of charge value.

Specifically, a reserve amount is added to the minimum SOC value as the lower limit of the predicted SOC to ensure a low temperature cold start of the engine. In another embodiment, the larger between the lower limit of the predicted SOC ensuring a low temperature cold start of the engine and the lower limit of the usage of the battery pack SOC defined by the battery supplier is served as the final lower limit of SOC value. If it is predicted that the temperature will decrease in the next 10 days, and the SOC value needs to be above 25% to start the vehicle normally, then adjusting the lower limit of the SOC from the fixed 15% to 25%, so that the SOC value cannot be lower than 25%, for example, the vehicle is stopped to used when the SOC value is lower than 25%, or keep charging above 25% when the SOC value is lower than 25%, which can solve the problem that after the power battery is powered off after the vehicle is stopped, the engine cannot be started and the vehicle cannot be used since the temperature of the power battery pack will decrease due to the decrease of the ambient temperature in the next 10 days, so that the discharge power of the battery does not meet the starting power requirement of the engine.

Fig. 3 is a structural block diagram of a device for controlling a lower limit of a state of charge of a power battery provided by an embodiment of the present disclosure. As shown in Fig. 3, the device includes: a detection unit 1, a prediction unit 2 and a processing unit 3. The detection unit 1 is configured for detecting a minimum ambient temperature for at least a period of time; the prediction unit 2 is configured for predicting a minimum ambient temperature within a preset period of time after the at least a period of time according to the minimum ambient temperature within the at least a period of time; and the processing unit 3 is configured for determining, according to the minimum ambient temperature within the preset period of time, a minimum state of charge value that able to meet power requirements for starting an engine of a vehicle under the minimum ambient temperature within the preset period of time; and adjusting a lower limit of the state of charge according to the minimum state of charge value.

In one embodiment, the minimum ambient temperature within the at least a period of time only includes a minimum ambient temperature within a first period of time, and the prediction unit 2 is configured for calculating the minimum ambient temperature within the preset period of time according to the minimum ambient temperature within the first period of time, a temperature constant, and a first ambient temperature predictive factor.

In one embodiment, the minimum ambient temperature within the at least a period of time includes a minimum ambient temperature within a first period of time and a minimum ambient temperature within a second period of time, the second period of time being after the first period of time, and the prediction unit 2 is configured for predicting the minimum ambient temperature within the preset period of time is the minimum ambient temperature within the first period of time, when determining that the minimum ambient temperature within the first period of time is less than or equal to the minimum ambient temperature within the second period of time.

In one embodiment, the minimum ambient temperature within the at least a period of time includes a minimum ambient temperature within a first period of time and a minimum ambient temperature within a second period of time, the second period of time being after the first period of time, and the prediction unit 2 is configured for calculating the minimum ambient temperature within the preset period of time according to the minimum ambient temperature within the first period of time, the minimum ambient temperature within the second period of time, and a second ambient temperature predictive factor, when determining that the minimum ambient temperature within the first period of time is larger than the minimum ambient temperature within the second period of time.

In one embodiment, the processing unit 3 is configured for substituting the minimum ambient temperature within the preset period of time in a discharge power Map of the power battery to obtain the minimum state of charge value.

The embodiments of the device for controlling a lower limit of a state of charge of a power battery described above are similar to the embodiments of the method for controlling a lower limit of a state of charge of a power battery described above, which will not be repeated here.

The present disclosure further provides a vehicle including the above-mentioned device for controlling a lower limit of a state of charge of a power battery.

The present disclosure further provides a machine-readable storage medium storing with instructions, and the instructions are configured to execute the method for controlling a lower limit of a state of charge of a power battery through a machine.

The embodiments of the vehicle and the machine-readable storage medium described above are similar to the embodiments of the method for controlling a lower limit of a state of charge of a power battery described above, which will not be repeated here.

The above descriptions are only embodiments of the present disclosure, and are not intended to limit the present disclosure. Any modifications, equivalent replacements, improvements, etc. made within the principles of the present disclosure shall be included within the scope of the present disclosure.

**Claims**

1. A method for controlling a lower limit of a state of charge of a power battery, comprising:

   detecting a minimum ambient temperature for at least a period of time;
   predicting a minimum ambient temperature within a preset period of time after the at least a period of time according to the minimum ambient temperature within the at least a period of time;
   determining, according to the minimum ambient temperature within the preset period of time, a minimum state of charge value that able to meet power requirements for starting an engine of a vehicle under the minimum ambient temperature within the preset period of time; and
   adjusting a lower limit of the state of charge according to the minimum state of charge value.

2. The method according to claim 1, wherein the minimum ambient temperature within the at least a period of time only comprises a minimum ambient temperature within a first period of time, and the step of predicting a minimum ambient temperature within a preset period of time after the at least a period of time according to the minimum ambient temperature within the at least a period of time comprises: calculating the minimum ambient temperature within the preset period of time according to the minimum ambient temperature within the first period of time, a temperature constant, and a first ambient temperature predictive factor.

3. The method according to claim 1, wherein the minimum ambient temperature within the at least a period of time comprises a minimum ambient temperature within a first period of time and a minimum ambient temperature within a second period of time, the second period of time being after the first period of time, and the step of predicting a minimum ambient temperature within a preset period of time after the at least a period of time according to the minimum ambient temperature within the at least a period of time comprises:
predicting the minimum ambient temperature within the preset period of time is the minimum ambient temperature within the first period of time, when determining that the minimum ambient temperature within the first period of time is less than or equal to the minimum ambient temperature within the second period of time.

4. The method according to claim 1, wherein the minimum ambient temperature within the at least a period of time comprises a minimum ambient temperature within a first period of time and a minimum ambient temperature within a second period of time, the second period of time being after the first period of time, and the step of predicting a minimum ambient temperature within a preset period of time after the at least a period of time according to the minimum ambient temperature within the at least a period of time comprises:
calculating the minimum ambient temperature within the preset period of time according to the minimum ambient temperature within the first period of time, the minimum ambient temperature within the second period of time, and a second ambient temperature predictive factor, when determining that the minimum ambient temperature within the first period of time is larger than the minimum ambient temperature within the second period of time.

5. The method according to claim 1, wherein the step of determining, according to the minimum ambient temperature within the preset period of time, a minimum state of charge value that able to meet power requirements for starting an engine of a vehicle under the minimum ambient temperature within the preset period of time comprises:
substituting the minimum ambient temperature within the preset period of time in a discharge power Map of the power battery to obtain the minimum state of charge value.

6. A device for controlling a lower limit of a state of charge of a power battery, comprising:

a detection unit, configured for detecting a minimum ambient temperature for at least a period of time;
a prediction unit, configured for predicting a minimum ambient temperature within a preset period of time after the at least a period of time according to the minimum ambient temperature within the at least a period of time; and
a processing unit, configured for:

determining, according to the minimum ambient temperature within the preset period of time, a minimum state of charge value that able to meet power requirements for starting an engine of a vehicle under the minimum ambient temperature within the preset period of time; and
adjusting a lower limit of the state of charge according to the minimum state of charge value.

7. The device according to claim 6, wherein the minimum ambient temperature within the at least a period of time only comprises a minimum ambient temperature within a first period of time, and the prediction unit is configured for:
calculating the minimum ambient temperature within the preset period of time according to the minimum ambient temperature within the first period of time, a temperature constant, and a first ambient temperature predictive factor.

8. The device according to claim 6, wherein the minimum ambient temperature within the at least a period of time comprises a minimum ambient temperature within a first period of time and a minimum ambient temperature within a second period of time, the second period of time being after the first period of time, and the prediction unit is configured for:
predicting the minimum ambient temperature within the preset period of time is the minimum ambient temperature within the first period of time, when determining that the minimum ambient temperature within the first period of time is less than or equal to the minimum ambient temperature within the second period of time.

9. The device according to claim 6, wherein the minimum ambient temperature within the at least a period of time comprises a minimum ambient temperature within a first period of time and a minimum ambient temperature within a second period of time, the second period of time being after the first period of time, and the prediction unit is configured for:
calculating the minimum ambient temperature within the preset period of time according to the minimum ambient temperature within the first period of time, the minimum ambient temperature within the second period of time, and a second ambient temperature predictive factor, when determining that the minimum ambient temperature within the first period of time is larger than the minimum ambient temperature within the second period of time.

**10.** The device according to claim 6, wherein the processing unit is configured for:
substituting the minimum ambient temperature within the preset period of time in a discharge power Map of the power battery to obtain the minimum state of charge value.

**11.** A vehicle, comprising the device for controlling a lower limit of a state of charge of a power battery according to any one of claims 6-10.

**12.** A machine-readable storage medium storing with instructions, wherein the instructions are configured to execute the method for controlling a lower limit of a state of charge of a power battery according to any one of claims 1 to 5 through a machine.

Step S11 — detecting a minimum ambient temperature for at least a period of time;

Step S12 — predicting a minimum ambient temperature within a preset period of time after the at least a period of time according to the minimum ambient temperature within the at least a period of time;

Step S13 — determining, according to the minimum ambient temperature within the preset period of time, a minimum state of charge value that able to meet power requirements for starting an engine of a vehicle under the minimum ambient temperature within the preset period of time;

Step S14 — adjusting a lower limit of the state of charge according to the minimum state of charge value.

Fig. 1

Step S211 — detecting a minimum ambient temperature for at least a period of time;

Step S212 — calculating the minimum ambient temperature within the preset period of time according to the minimum ambient temperature within the first period of time, a temperature constant, and a first ambient temperature predictive factor

Step S213 — determining, according to the minimum ambient temperature within the preset period of time, a minimum state of charge value that able to meet power requirements for starting an engine of a vehicle under the minimum ambient temperature within the preset period of time;

Step S214 — adjusting a lower limit of the state of charge according to the minimum state of charge value.

Fig. 2A

Step S221 — detecting a minimum ambient temperature for at least a period of time;

Step S222 — determining whether the minimum ambient temperature within the first period of time is less than or equal to the minimum ambient temperature within the second period of time;

No → Step S224 — calculating the minimum ambient temperature within the preset period of time according to the minimum ambient temperature within the first period of time, the minimum ambient temperature within the second period of time, and a second ambient temperature predictive factor;

Yes

Step S223 — predicting the minimum ambient temperature within the preset period of time is the minimum ambient temperature within the first period of time;

Step S225 — determining, according to the minimum ambient temperature within the preset period of time, a minimum state of charge value that able to meet power requirements for starting an engine of a vehicle under the minimum ambient temperature within the preset period of time;

Step S226 — adjusting a lower limit of the state of charge according to the minimum state of charge value.

Fig. 2B

detection unit 1

prediction unit 2

processing unit 3

Fig. 3

**INTERNATIONAL SEARCH REPORT**

| International application No. |
|---|
| **PCT/CN2021/077832** |

**A.    CLASSIFICATION OF SUBJECT MATTER**

B60L 58/12(2019.01)i

According to International Patent Classification (IPC) or to both national classification and IPC

**B.    FIELDS SEARCHED**

Minimum documentation searched (classification system followed by classification symbols)

B60L

Documentation searched other than minimum documentation to the extent that such documents are included in the fields searched

Electronic data base consulted during the international search (name of data base and, where practicable, search terms used)

CNABS, CNTXT, VEN, 电池, 电荷, 荷电, 下限, 阈值, 调整, 调节, 温度, 气温, 预测, 预告, 预计, batter+, cell+, SOC+, limit +, value+, low+, adjust+, temperature+, forecast+, estimat+.

**C.    DOCUMENTS CONSIDERED TO BE RELEVANT**

| Category* | Citation of document, with indication, where appropriate, of the relevant passages | Relevant to claim No. |
|---|---|---|
| X | CN 110281858 A (FORD GLOBAL TECHNOLOGIES, LLC.) 27 September 2019 (2019-09-27)<br>description, paragraphs [0029]-[0091], and figures 1-4 | 1-2, 5-7, 10-12 |
| A | CN 103529395 A (GREAT WALL MOTOR CO., LTD.) 22 January 2014 (2014-01-22)<br>entire document | 1-12 |
| A | CN 104638318 A (FUAO AUTO PARTS CO., LTD.) 20 May 2015 (2015-05-20)<br>entire document | 1-12 |
| A | JP 2012080689 A (PANASONIC CORP.) 19 April 2012 (2012-04-19)<br>entire document | 1-12 |
| A | CN 107817685 A (CHINA INFORMATION DEVELOPMENT INC., LTD. SHANGHAI) 20 March 2018 (2018-03-20)<br>entire document | 1-12 |

☐ Further documents are listed in the continuation of Box C.          ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **16 April 2021** | **28 May 2021** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

International application No.

**PCT/CN2021/077832**

| Patent document cited in search report | | | Publication date (day/month/year) | Patent family member(s) | | | Publication date (day/month/year) |
|---|---|---|---|---|---|---|---|
| CN | 110281858 | A | 27 September 2019 | DE | 102019106167 | A1 | 19 September 2019 |
| | | | | US | 2019285041 | A1 | 19 September 2019 |
| | | | | US | 10746151 | B2 | 18 August 2020 |
| CN | 103529395 | A | 22 January 2014 | CN | 103529395 | B | 30 March 2016 |
| CN | 104638318 | A | 20 May 2015 | CN | 104638318 | B | 09 November 2016 |
| JP | 2012080689 | A | 19 April 2012 | None | | | |
| CN | 107817685 | A | 20 March 2018 | CN | 107817685 | B | 11 December 2020 |

Form PCT/ISA/210 (patent family annex) (January 2015)

EP 4 063 178 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010115664